Europäisches Patentamt

European Patent Office

Office européen des brevets

(19)

(11) Publication number: **0 128 634**
**B1**

(12) # EUROPEAN PATENT SPECIFICATION

(45) Date of publication of patent specification: **08.06.88**

(51) Int. Cl.⁴: **H 01 H 43/10, H 05 B 6/68**

(21) Application number: **84300914.3**

(22) Date of filing: **14.02.84**

(54) A control system for an electrical appliance.

(30) Priority: **18.05.83 US 495895**

(43) Date of publication of application:
**19.12.84 Bulletin 84/51**

(45) Publication of the grant of the patent:
**08.06.88 Bulletin 88/23**

(84) Designated Contracting States:
**DE FR GB IT**

(56) References cited:
**EP-A-0 077 133**
**DE-A-2 709 859**
**US-A-3 824 365**
**US-A-4 242 746**

(73) Proprietor: **EATON CORPORATION**
**100 Erieview Plaza**
**Cleveland Ohio 44114 (US)**

(72) Inventor: **Mahon, Joseph John**
**818 Hayes Avenue**
**Libertyville Illinois 60048 (US)**

(74) Representative: **Douglas, John Andrew**
**Eaton House Staines Road**
**Hounslow Middlesex TW4 5DX (GB)**

## Description

The present invention relates to program timing for electrically operated appliances and in particular relates to program timing for microwave cooking appliances.

Heretofore, control of the inverval or duration of electrical energization of a microwave cooking device has been effected by employing a set of switch contacts opened and closed by rotation of a cam drum advanced by a mechanism driven from a sub-fractional horsepower timing motor. Typically in such applications, the cam drum is initially rotated manually by the appliance operator to a position representing the desired cooking interval and the manual rotation of the drum closes a set of contacts for starting the timing motor and a set of contacts for energizing the microwave magnetron.

In such an arrangement, the cam drum is thereafter rotated by the timing motor by the amount representing the selected cooking program interval or "time-out"; and, the cam drum is operable to open the contacts for de-energizing the magnetron and cutting off power to the timing motor. Thus, heretofore, upon termination of the cooking program interval, the appliance was automatically turned off by the programmer timer.

However, where a more sophisticated or complex cooking program has been desired, as for example intermitent or variable magnetron operation during the cooking interval, it has been found necessary to employ a plurality of timer motors for activating separate timing programmers alternatively, electronic timing means have been employed which included solid state switching relay devices to handle the power required for energization of the magnetron. Such plural motor programmers or electronic timer programmers have been costly to manufacture. Thus, it has been desired to find a simple low-cost technique for expanding the capabity of the programmer timer and yet employ only a single timing motor to drive the cam drum for actuating plurality of circuit function control switches.

In particular it has been desirable to find a way or means of providing partial or intermittent energization of a microwave cooking magnetron upon completion of the cooking cycle for purposes of maintaining the cooked food in a warm state. Prior techniques of providing a post-cooking "KEEP-WARM" mode of operation have required additional timing mechanisms or expensive solid state electronic control circuitry. Thus it has long been desired to provide such a "KEEP-WARM" function for a microwave cooking oven without incurring the cost of replacing the simple single timing motor actuated programmer timer.

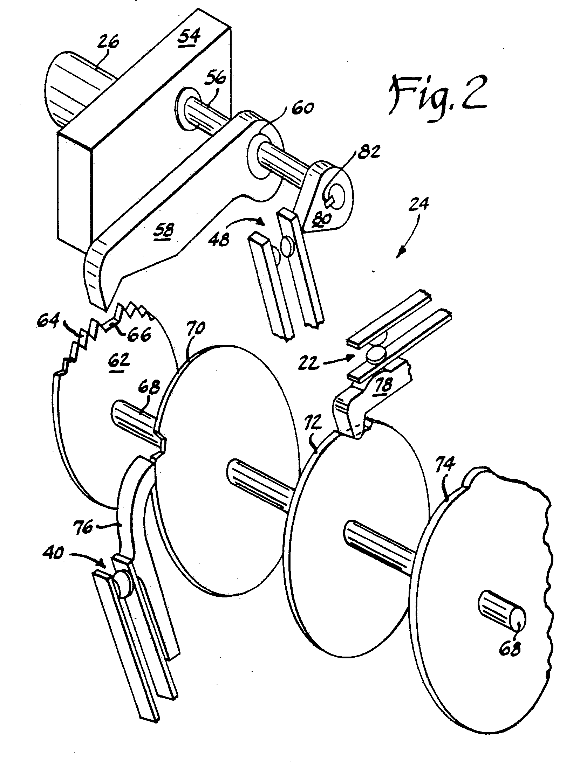

US—A—3 824 365 (Fig. 2) describes a microwave oven where a single motor drives a timer and also a sub-interval cycling arrangement for defrosting which is entirely automatically switched out as well as in. This is unsuitable for functions such as "KEEP-WARM" which are to be selected and terminated by the housewife. This reference discloses the pre-characterizing parts of independent Claims 1 and 6, the characterizing portions of which propose features simply facilitating such an extra function (including an optional alarm).

Embodiments provide a simple low cost electromechanical programmer timer powered by a single sub-fractional horsepower synchronous timing motor driving a cam drum for actuating a plurality of circuit function control switches. The timing motor is connected through a gear reduction train to drive an oscillating advance pawl operative to successively index a ratchet wheel for rotating a cam drum. The drum has a plurality of cam tracks each operable to actuate and de-actuate a set of switch contacts in the appropriate sequence and for a desired interval.

The ratchet wheel is provided with a toothless space immediately prior to the "time-out" or shut-off position. The advance pawl, upon contacting the toothless space, is rendered inoperative to advance the ratchet wheel. The magnetron is de-energized prior to the advance pawl reaching the toothless space; however, the timing motor continues to run thereby providing advance pawl oscillation. A sub-interval cam is provided on the drive shaft providing the pawl oscillation and a set of switch contacts responsive to the sub-interval cam causes the magnetron to be cycled at the rate of rotation of the sub-interval cam. The sub-interval cam rotation provides for continued cyclic energization of the magnetron for only a minor fraction of the sub-interval cycle thereby providing a "KEEP-WARM" mode of operation.

An optional alarm bell is provided which is also cycled by the sub-interval cam to provide a reminder that the appliance is operating in the "KEEP-WARM" mode.

When it is desired to terminate the "KEEP-WARM" mode of operation, it is necessary for the appliance operator to manually advance the cam drum to acuate the switch contacts for cutting off power to the timing motor.

Figure 1 is an electrical schematic of a control system for a microwave cooking appliance;

Figure 2 is an exploded pictorial in perspective of the programmer timer mechanism of the present invention;

Figure 3 is a plan view of a portion of one embodiment of the programmer timer of the present invention; and

Figure 4 is an enlarged section view taken along section indicating lines 4—4 of Figure 3.

## Detailed Description

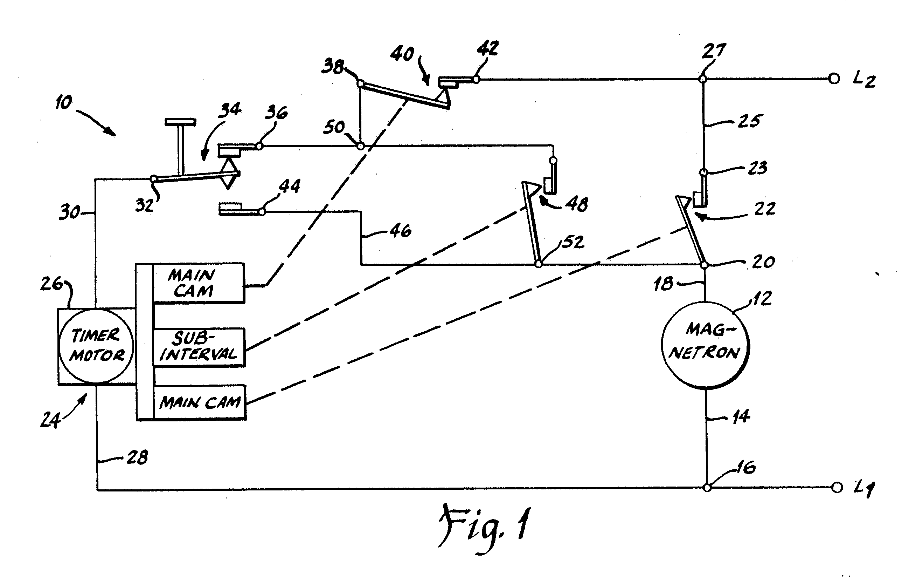

With reference to Figure 1 to a control system indicated generally at 10 is illustrated which the invention is embodied in a microwave cooking oven having an electrically energized magnetron 12 operative to emit radio frequency radiation for cooking. One power lead 14 from the magnetron is connected through junction 16 to one side of a power line $L_1$ and the other power lead 18 of the magnetron is connected to junction 20 which comprises the one terminal of a magnetron power switch indicated generally at 22. The remaining terminal of switch 23; connected via level 25 to junction 27 on power line L₂.

A programmer timer indicated generally at 24 has a timing motor 26, preferably of the subfractional horsepower synchronous type, with one power lead 28 thereof connected to power line junction 16. The remaining power lead 30 of the timing motor is connected to junction 32 which comprises the common terminal of a single pole double throw MODE SELECTOR switch indicated generally at 34 which is manually operated. Switch 34 has one stationary contact thereof connected via junction 36 to connecting terminal 38 of a timer power switch indicated generally at 40. Switch 40 has one stationary contact thereof connected via terminal 42 to the remaining side of the power line L₂.

The remaining stationary contact of switch 34 is connected via terminal 44 and lead 46 to junction 20.

A switch indicated generally at 48 is connected across the power line L₂ and lead 46 by connecting junctions 50, 52. Switch 48 is thus in parallel with switch 22. With reference to Figure 1, it will be understood that closure of either switch 22 will energize magnetron 12 irrespective of the position of switch 40; whereas, switch 48 can energize magnetron 12 only in the event switch 40 is closed.

Referring now to Figures 1 and 2, the timer motor 26 is connected to a gear box 54 having an output shaft 56 rotatable at a suitable rate, which in the presently preferred practice invention is four revolutions per minute. An advance pawl 58 is connected to shaft 56 by means of having an end thereof apertured and received over an eccentric 60 on the shaft such that pawl 58 is oscillated thereby upon rotation of the shaft 56.

An advance ratchet 62 is provided having a plurality of ratchet teeth 64 provided about the periphery thereof for engagement by the free end of advance pawl 58 which is suitably chisel-pointed. The wheel 62 has a toothless space 66 provided about the periphery thereof for permitting the oscillating pawl 58 to engage the ratchet wheel 62 in lost-motion engagement for preventing indexing of the ratchet wheel.

Ratchet wheel 62 is connected to a cam shaft or drum 68 in a rotationally driving connection such that advancement of the ratchet wheel 62 by pawl 58 indexes the drum 68.

Drum 68 has a plurality of spaced peripheral cam tracks 70, 72, 74 preferably spaced axially therealong for rotation with shaft 68. Cam track 70 has a cam follower 76 in contact therewith and switch 40 is disposed for actuation by the cam follower 76.

Cam track 72 similarly has a cam follower 78 in contact therewith for effecting actuation of switch 22 which is appropriately disposed adjacent follower 78.

The eccentric shaft 56 has a sub-interval cam lobe 80 provided thereon and secured by any suitable expedient, as for example key 82, for rotation with the shaft 56. Cam lobe 80 has switch 48 disposed in contact therewith for cyclic actuation and de-actuation upon rotation of cam lobe 80.

Referring now to Figure 2, the cam tracks 70, 72, 74 are so disposed and configured in the presently preferred arrangement that, upon completion of the program interval or "time-out", cam follower 78 moves to effect opening of switch 22 for cutting off power to the magnetron as the advance pawl contacts the toothless space 66 on ratchet wheel 62. The consequent lost motion movement of the pawl 58 is space 66 permits ratchet wheel 62 to remain stationary. With ratchet wheel 62 stationary in the position shown in Figure 2, cam follower 76 maintains switch 40 in the closed position thereby continuing power to timer motor 26 for continuing rotation of shaft 56.

Continued rotation shaft 56 causes cam 82 to effect cycling of switch 48 at the sub-interval frequency; and, in the presently preferred practice, maintains switch 48 open for a minor fraction of the sub-interval period of cam 82. This minor fraction sub-interval duty cycle of switch 48 in turn causes the magnetron to be pulsed "ON" for periods of time and at spaced intervals sufficient only to provide a "KEEP WARM" functional mode of operation and insufficient "ON" time to effect further cooking.

When it is desired to discontinue the "KEEP WARM" mode of operation, the ratchet wheel 62 and cam drum are manually advanced a small amount by the appliance operator to cause cam track 70 to effect movement of cam follower 76 for opening switch 40. Switch 40 cuts off power to the timer motor and thereby stopping the cycling of switch 48.

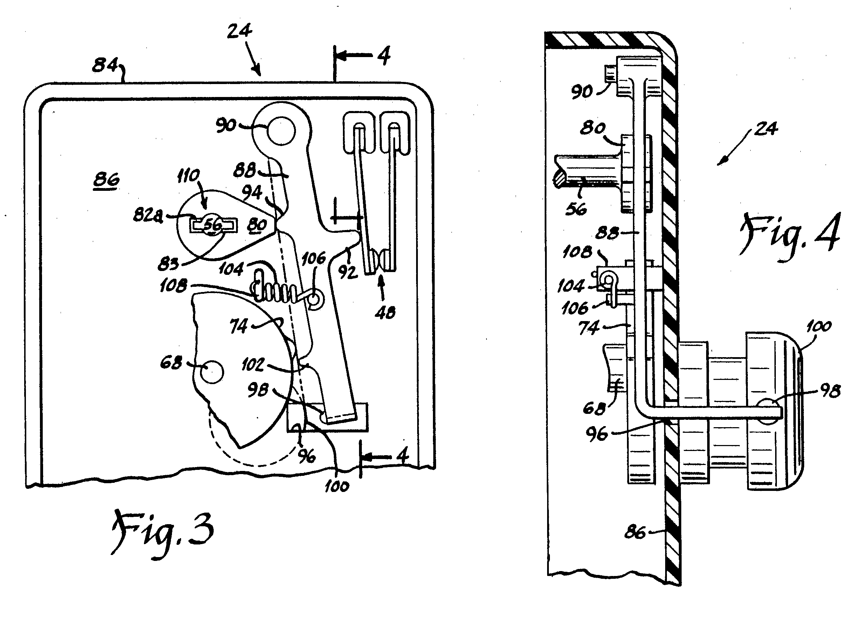

Referring now to Figures 3 and 4, the feature of the invention is illustrated wherein, during the "KEEP WARM" mode of operation, an alarm bell is continuously cycled indicating that the appliance is operating in "KEEP WARM" mode. In the embodiment of Figures 3 and 4, the programmer timer 24 is mounted in a housing or body 84 having a wall or mounting deck 86 apertured to receive drive shaft 56 therethrough. Sub-interval cam 80 is disposed adjacent the upper surface of the deck or the left hand side as shown in Figure 4.

In the embodiment of Figures 3 and 4 a moveable arm 88 is pivotally mounted at one end thereof about pin 90 which extends from the left hand or upper surface of the deck 86 and has an actuator portion 92 preferably formed integrally therewith, for contacting the blade of switch 48. Arm 88 has a cam follower 94 formed thereon for contact with the lobe on sub-interval cam 80. The free end of arm 88 is formed at right angles to the upper or left hand surface of the deck 86 and extends through an aperture 96 formed in the deck. The end of arm 88 which extends through aperture 96 has attached thereto a suitable striker of clapper 98 disposed for impact against an alarm bell 100 mounted on the lower or right hand side of the deck 86.

Arm 88 also has cam follower 94 disposed intermediate the ends thereof. A second cam follower 102 is disposed intermediate the free end of arm 88 and cam follower 94. Shaft 68 and cam track 74 (see Figure 2) are disposed adjacent the upper or left hand face of deck 86 such that cam follower 102 on arm 88 is in a position for contacting cam track 74.

With reference to Figure 3, sub-interval cam 80 is shown as contacting cam follower 94 in solid outline in the position of maximum lift by cam 80. Switch actuating portion 92 has closed switch 48 and striker 98 is lifted from contacting bell 100. In the position of maximum lift shown in Figure 3, arm 88 also prevents cam follower 102 on arm 88 from contacting cam track 74.

A bias spring 104 has one end thereof anchored to a lug 106 provided on arm 88 and the other end anchored to a stationary lug 108 extending from the upper left hand face of deck 86. Spring 104 thus biases arm 88 leftward in Figure 3 or in a direction to urge the cam follower 94 into contact with sub-interval cam 80 and cam follower 102 into contact with cam track 74.

In the presently preferred practice of the invention, the drive shaft 56 has a lost motion connection indicated generally at 110 wherein shaft 56 has a key 82a provided thereon and preferably in the form of a double headed key. Cam lobe 80 has a slot 83 provided therein and configured to conform generally to the shape of the double headed key 82a. Slot 83 is configured so as to permit a desired amount of rotational movement of shaft 56 before causing rotational movement of cam lobe 80. This minor amount of rotational lost motion is operative to cause a snap-action of the cam 80 when follower 94 is in contact with the descending ramp of the cam lobe. This sudden or rapid rotational movement of the cam lobe 80 upon follower 94 encountering the descending ramp thereof, permits a sudden drop of striker 98 onto the bell 100 providing the cam lobe on track 74 is not engaging cam follower 102 to prevent fall or leftward movement of the arm 88. The position of arm 88 in the bell striking position is shown in dashed outline in Figure 3.

In operation, upon the advance pawl 58 encountering the toothless space 66 on rachet wheel 62, rotation of the cam drum shaft 68 is terminated and cam track 70 maintains switch 40 closed. The timer motor 26 continues to run and to cycle cam lobe 80 for raising and lowering arm 88 thereby cycling magnetron switch 48 and the striker against bell 100. In the position shown in Figure 3, cam track 74 does not prevent the striker 98 from contacting bell 100. When the appliance operator desires to terminate the "KEEP WARM" operational mode, cam drum shaft 68 is manually advanced by the operator causing cam follower 76 to drop into the notch on cam track 70 for opening switch 40 to stop the timing motor.

With reference to Figure 3, when the advanced pawl 58 rotates cam drum shaft 68 such that cam track 72 causes cam follower 78 to open the magnetron switch 22 for the end of the "COOK" cycle, cam track 74 is operative to cause the lobe thereon to engage cam follower 102 on arm 88 thereby lifting the arm and permitting the lobe to pass by follower 100 and permitting the striker 98 to contact bell 102 to thereby signal the end of the "COOK" cycle. It will be understood that upon completion of the "COOK" cycle arm 88 is thereafter cycled by rotation of the sub-interval cam 80. Thus, cam track 74 must have a diameter sufficiently small to permit the follower 102 to drop without contacting the cam track to thereby enable the striker 98 to contact bell 100.

The present invention thus provides a novel control of an electrical appliance and particularly a microwave cooking oven, in a manner permitting the appliance to be pulsed for short duration "ON" time upon completion of the normal "COOK" mode of operation. The present inventtion permits the appliance to continue intermittent "KEEP WARM" mode of operation upon the conclusion of normal duty cycle. An audible warning that such intermittent operations is, in process is provided until such time as the operator manually advances the programmer cam drum to shut the power off to the appliance and programmer timer.

**Claims**

1. A control system for an electrical cooking appliance comprising:

(a) means (12) operable upon connection to a source (L1, L2) of electrical power to provide radiant energy for cooking;

(b) first switch means (22) operable upon actuation to make and upon de-actuation to break a circuit between said radiant energy provider and said source of power;

(c) programmer timer means (24) having a single timing motor (26) and operable upon electrical energization to provide a pre-selected cooking interval of actuation for said first switch means (22);

(d) second switch means (40) operable upon actuation to make and upon de-actuation to break a connection between said timer motor (26) and said source of power;

(e) third switch means (48) electrically in parallel with said first switch means (22) and operable upon actuation to complete and upon de-actuation to break a circuit between said radiant energy provider (12) and said power source (L1, L2);

(f) said programmer timer means (24) including first cam means (72) operable to effect actuation of said first switch means (22) for a pre-selected program interval and third cam means (80) operable to actuate and de-actuate said third switch means (48) at sub-intervals of said program interval and second cam means (70) operable to effect actuation of said second switch means (40) for a predetermined interval for maintaining said timer motor energized when said first and third switch means are de-actuated; and

(g) mode selector switch means (34) operable upon user actuation characterized in that it is a further switch which in one position enables energization of said radiant energy source through said second (40) and third (48) switch means and when operable upon user actuation to another position enables energization of said radiant energy source only through said first switch means (22);

(h) said programmer timer means includes dwell means (66) operable to prevent actuation of said first switch (22) means when said mode selector is in said one position and said second switch means (40) is actuated.

2. The control system defined in claim 1, wherein said dwell means (66) includes an oscillating advance pawl (58), a driving ratchet (62) indexed by said pawl and a notch in said ratchet operative to prevent ratchet indexing upon contact of said notch by said pawl.

3. The control system defined in claim 1 or 2, wherein said sub-interval cam means (80) is rotated by said motor and has a period of rotation equal to said sub-interval; and, said cam means (80) operative to effect said actuation of said third switch means (48) comprises a cam follower (94) contacting said sub-interval cam means (80).

4. The control system defined in claim 1, 2 or 3, further comprising alarm means (100) operably responsive to and cycling of said sub-interval cam means (80).

5. The control system defined in claim 1, wherein said sub-interval cam means (80) includes a lost-motion driving connection with said programmer timer means.

6. The control system for an electrical appliance comprising:

(a) first circuit means including first switch means (22) operable upon actuation to connect and upon deactuation to disconnect the appliance function load to a source of electrical power;

(b) timer means (24) operable upon electrical energization;

(c) first cam track means (72);

(d) second cam track means (70);

(e) sub-interval cam means (80) operably driven by said timer means (24);

(f) first circuit means including a second switch means (40) operable upon actuation to electrically energize and upon deactuation to de-energize said programmer timer means (24);

(g) second circuit means including third switch means (48) electrically in parallel with said first switch means (22), said third switch means (48) being operable upon actuation to connect and upon deactuation to disconnect said appliance function load to said power line through said second switch means (40), said third switch means (48) including cam follower means (94) responsive to said sub-interval cam means (80) for cycling said third switch means (48);

(h) said second switch means (40) including cam follower means (76) responsive to said second cam track (70) to cycle said timer means, said first switch means (22) including cam follower means (78) responsive to said first cam track (72) for cycling said appliance load function; and,

(i) mode selector switch means (34) operable upon user actuation characterized in that it is a further switch which when actuated to one position selects said second circuit means for current flow to said timer means and operable upon user actuation to another position to by-pass said second circuit means and provide current to said timer means through said first circuit means;

(j) said timer means (24) is operable to advance a driving pawl (58) able to index ratchet means (62), and said ratchet means is coupled so that, when indexed, the first and second cam track means are indexed, said sub-interval cam means (80) cycling with a period generally equal to the cyclic advance of the pawl, and

(k) said ratchet means (62) includes dwell means (66) operable upon contact with said pawl (58) to prevent said pawl advance from further indexing of said ratchet means until said ratchet means is actually advanced past said dwell means wherein said first cam track causes said first switch means (22) to be de-actuated when said dwell means (66) prevents said indexing and said sub-interval cam means (80) cycles power to said load through said third switch means (48).

7. The control system defined in claim 6, wherein said sub-interval cam means (80) is operative to actuate said third switch means (48) for a minor portion of said sub-interval period.

8. The control system defined in claim 6 or 7, wherein said dwell means (66) and said second cam track (70) are arranged to maintain said second switch (40) actuated during and beyond the interval of actuation of said first switch means (22) such that said timer means (24) continues to cycle said sub-interval cam means (80).

9. The control system defined in claim 6, 7 or 8, further comprising alarm means operable in response to cycling of said sub-interval cam means (80).

10. The control system defined in claim 6, 7, 8 or 9, wherein said sub-interval cam means (80) includes means effecting a lost-motion driving connection with said timer means (24).

**Patentansprüche**

1. Steuerungssystem für ein elektrische Kochgerät, das folgende Merkmale aufweist:

a) eine Vorrichtung (12), die beim Anschluß an eine elektrische Energiequelle (L1, L2) Strahlungsenergie zum Kochen erzeugt;

b) erste Schaltermittel (22), die beim Ein- und Ausschalten einen Schaltkreis zwischen dem Strahlungsenergieerzeuger und der Energiequelle herstellen bzw. unterbrechen;

c) eine Programmzeitgebervorrichtung (24) mit einem einzigen Zeitgebermotor (26), die bei elektrischer Erregung ein vorgewähltes Kochintervall zum Einschalten für die ersten Schaltermittel gibt;

d) zweite Schaltermittel (40), die beim Ein- und Ausschalten eine Verbindung zwischen dem Zeitgebermotor und der Energiequelle herstellen bzw. unterbrechen;

e) dritte Schaltermittel (48), die elektrisch mit den ersten Schaltermitteln parallel geschaltet sind und beim Ein- und Ausschalten einen Schaltkreis zwischen dem Strahlungsenergieerzeuger (12) und die Energiequelle (L1, L2) herstellen bzw. unterbrechen;

f) die Programmzeitgebervorrichtung (24) weist erste Nockenmittel (72), die ein Einschalten der ersten Schaltermittel (22) während eines vorgewählten Programmintervalles bewirken und dritte Nockenmittel (80), welche die dritten Schaltermittel (48) während Unterintervallen des Programmintervalls ein- und ausschalten sowie zweite Nockenmittel (70) auf, welche die zweiten Schaltermittel (40) während eines vorbestimmten Zeitintervalles einschalten, um den Zeitgebermotor erregt zu halten, während die ersten und die dritten Schaltermittel ausgeschaltet sind;

g) eine Betriebsartenwahlschaltervorrichtung (34), die von dem Benutzer betätigbar ist und die dadurch gekennzeichnet ist, daß sie ein weiterer Schalter ist, der in einer Stellung die Erregung der Strahlungsenergiequelle über die zweiten (40) und dritten Schaltermittel (48) ermöglicht und, wenn er durch den Benutzer in eine andere Stellung gebracht wird, die Erregung der Strahlungsenergiequelle nur über die ersten Schaltermittel (22) erlaubt;

h) die Programmzeitgebervorrichtung enthält eine Verweileinrichtung (66), die ein Einschalten der ersten Schaltermittel (22) verhindert, wenn sich der Betriebsartenwahlschalter in der einen Stellung befindet und die zweiten Schaltermittel (40) eingeschaltet sind.

2. Steuerungssystem nach Anspruch 1, bei der die Verweileinrichtung (66) eine hin- und hergehende Fortschaltklinke (58), eine Antriebsschaltscheibe (62), die durch die Fortschaltklinke schrittweise weitergeschaltet wird und eine Aussparung in der Schaltscheibe aufweist, durch welche eine Weiterschaltung der Schaltscheibe bei Berührung der Aussparung durch die Fortschaltklinke verhindert wird.

3. Steuerungssystem nach Anspruch 1 oder 2, bei dem die Unterintervall-Nockenmittel (80) durch den Motor in Umdrehung versetzt werden und eine Umlaufzeit haben, die gleich dem Unterintervall ist und diese Nockenmittel (80), welche zum Einschalten der dritten Schaltermittel (48) dienen, einen Nockenabtaster (94) aufweisen, welcher die Unterintervall-Nockenmittel (80) berührt.

4. Steuerungssystem nach Anspruch 1, 2 oder 3, welches weiterhin eine Alarmvorrichtung (100) enthält, welche abhängig von den Unterintervall-Nockenmitteln (80) und deren zyklischer Bewegung betätigbar ist.

5. Steuerungssystem nach Anspruch 1, bei der die Unterintervall-Nockenmittel (80) eine Totgang aufweisende Antriebsverbindung mit der Programmzeitgebervorrichtung aufweisen.

6. Steuerungssystem für ein elektrisches Gerät, das folgende Merkmale aufweist:

a) erste Schaltkreismittel mit ersten Schaltermitteln (23), die beim Ein- und Ausschalten die Funktionslast des Gerätes an eine elektrische Energiequelle anschließen bzw. von dieser trennen;

b) eine Zeitgebervorrichtung (24), die bei elektrischer Erregung wirksam wird;

c) erste Nockenbahnmittel (72);

d) zweite Nockenbahnmittel (70);

e) Unterintervall-Nockenmittel (80), die durch die Zeitgebervorrichtung (24) angetrieben werden;

f) die ersten Schaltkreismittel enthalten zweite Schaltermittel (40), welche beim Ein- und Ausschalten die Programmzeitgebervorrichtung mit elektrischer Energie versorgen bzw. von der Energieversorgung abtrennen;

g) zweite Schaltkreismittel mit dritten Schaltermitteln (48), welche zu den ersten Schaltermitteln (22) elektrisch parallelgeschaltet sind, wobei die dritten Schaltermittel (48) beim Ein- und Ausschalten die Funktionslast des Gerätes mit der Stromversorgung über die zweiten Schaltermittel (40) verbinden bzw. von der Stromversorgung abtrennen und die dritten Schaltermittel (48) die Nockenabtastmittel (94) enthalten, die von den Unterintervall-Nockenmitteln, angesteuert werden, um die dritten Schaltermittel (48) zyklisch zu betätigen;

h) die zweiten Schaltermittel (40) enthalten Nockenabtastmittel (76), die von der zweiten Nockenbahn (70) angesteuert sind, um die Zeitgebervorrichtung zyklisch zu betätigen, wobei die ersten Schaltermittel (22) Nockenabtastmittel (78) aufweisen, welche von der Nockenbahn (72) angesteuert sind, um die Gerätefunktionslast zyklisch zu schalten; und

i) eine Betriebsartenwahlschaltervorrichtung (34), die von dem Benutzer betätigbar ist und dadurch gekennzeichnet ist, daß sie ein weiterer Schalter ist, der, wenn er in eine Stellung gebracht ist, die zweiten Schaltkreismittel für den Stromfluß zu der Zeitgebervorrichtung auswählt, und wenn er durch den Benutzer in eine zweite Stellung gebracht wird, die zweiten Schaltkreismittel umgeht und der Zeitgebervorrichtung Strom über die ersten Schaltkreismittel zuleitet;

j) die Zeitgebervorrichtung (24) bewirkt die Bewegung einer Antriebsklinke (58), die eine Schaltscheibe (62) schrittweise weiterschalten kann, wobei die Schaltscheibe derart gekuppelt ist, daß bei ihrer Fortschaltung die ersten und zweiten Nockenbahnmittel fortgeschaltet werden und die Unterintervall-Nockenmittel (80) sich mit einer Periode zyklisch bewegen, die im wesentlichen gleich dem zyklischen Vorschub der Klinke ist; und

k) die Schaltscheibe (62) enthält eine Verweileinrichtung (66), welche dazu dient, bei Berührung mit der Klinke (58) zu verhindern, daß der Klinkenvorschub die Schaltscheibe weiter fortschaltet, bis die Schaltscheibe tatsächlich über die Verweileinrichtung hinausbewegt ist, wobei die erste Nockenbahn bewirkt, daß die ersten Schaltermittel (22) abgeschaltet werden, wenn die Verweileinrichtung (66) die Fortschaltung verhindert und die Unterintervall-Nockenmittel (80) der Funktionslast des Gerätes über die dritten Schaltermittel (48) zyklisch Energie zuzuführen.

7. Steuerungssystem nach Anspruch 6, bei dem die Unterintervall-Nockenmittel (80) die dritten Schaltermittel (48) während eines kurzen Zeitabschnittes des Unterintervalls einschalten können.

8. Steuerungssystem nach Anspruch 6 oder 7, bei dem die Verweil richtung (66) und die zweite Nockenbahn (70) derart ausgebildet sind, daß sie den zweiten Schalter (40) wahrend und nach dem Einschaltintervall des ersten Schalters eingeschaltet halten, so daß die Zeitgebervorrichtung (24) fortfährt, die Unterintervall-Nockenmitte (80) zyklisch zu bewegen.

9. Steuerungssystem nach Anspruch 6, 7 oder 8, das darüber hinaus eine Alarmvorrichtung enthält, die abhängig von der zyklischen Bewegung der Unterintervall-Nockenmittel (80) betätigt wird.

10. Steuerungssystem nach Anspruch 6, 7, 8 oder 9, bei dem die Unterintervall-Nockenmittel (80) Mittel enthalten, die eine Totgang enthaltende Anstriebsverbindung mit der Zeitgebervorrichtung (24) herstellen.

**Revendications**

1. Système de commande pour un appareil de cuisson électrique comprenant:

(a) des moyens (12) actionnables par suite de la connexion à une source (L1, L2) d'alimentation électrique pour fournir une énergie rayonnante pour une cuisson;

(b) des premiers moyens de commutation (22) fonctionnant à la suite de leur activation pour établir un circuit électrique et à la suite de leur désactivation pour interrompre ce circuit entre le dispositif d'énergie rayonnante et la source d'alimentation.

(c) des moyens de programmateur (24) comprenant un moteur de temporisation unique (26) et actionnables par suite de leur alimentation électrique pour fournir un intervalle de cuisson présélectionné d'actionnement pour les premiers moyens de commutation (22);

(d) des seconds moyens de commutation (40), fonctionnant à la suite de leur activation pour établir, et à la suite de leur désactivation pour interrompre; une connexion entre le moteur de temporisation (26) et la source d'alimentation;

(e) des troisièmes moyens de commutation (48) disposés électriquement en parallèle avec les premiers moyens de commutation (22) et actionnables à la suite de leur activation pour fermer, et à la suite de leur désactivation pour ouvrir, un circuit entre la source d'énergie rayonnante (12) et la source d'alimentation (L1, L2);

(f) les moyens de programmateur (24) comprenant des premier moyens de came (72) actionnables pour assurer l'activation des premiers moyens de commutation (22) pendant un intervalle de programme présélectionné et des troisèmes moyens de came (80) agissant pour activer et désactiver les troisèmes moyens de commutation (48) à des sous-intervalles de l'intervalle du programme et des seconds moyens de came (70) agissant pour effectuer l'activation des seconds moyens de commutation (40) pendant un intervalle prédéterminé pour maintenir le moteur de temporisation alimenté quand les premiers et troisièmes moyens de commutation sont désactivés; et

(g) des moyens de commutation sélecteurs de mode (34) actionnables par suite d'une activation par l'utilisateur, caractérisé en ce qu'il s'agit d'un autre commutateur qui dans une première position permet l'alimentation de la source d'énergie rayonnante par l'intermédiaire des seconds (40) et troisièmes (48) moyens de commutation et, quand il est actionée par suite de l'activation de l'utilisateur vers une autre position permet l'alimentation de la source d'énergie rayonnante seulement par l'intermédiaire des premiers moyens de commutation (22);

(h) les moyens de programmateur comprenant des moyens de retard (66) agissant pour empêcher l'activation des premiers moyens de commutation (22) quand le sélecteur de mode est dans la première position et que les seconds moyens de commutation (40) sont activés.

2. Système de commande selon la revendication 1, dans lequel les moyens de retard (66) comprennent un cliquet d'avance oscillant (58), une roue à rochet d'entraînement (62) commandée par le cliquet et une econche dans la roue à rochet agissant pour empêcher l'avancement de la roue à rochet par suite du contact de l'encoche avec le cliquet.

3. Système de commande selon l'une des revendications 1 ou 2, caractérisé en ce que les moyens de came de sous-intervalle (80) sont entraînés en rotation par la moteur et ont une période de rotation égale audit sous-intervalle; et en ce que les moyens de came (80) agissant pour effectuer l'activation des troisièmes moyens de commutation (48) comprennant un suiveur de came (94) en contact avec les moyens de came de sous-intervalle (80).

4. Système de commande selon l'une des revendications 1, 2 ou 3, comprenant en outre des moyens d'alarme (100) agissant en réponse à un fonctionnement cyclique des moyens de sous-intervalle (80).

5. Système de commande selon la revendication 1, dans lequel les moyens de came de sous-intervalle (80) comprennent une connexion d'entraînement à perte de course avec les moyens de programmateur.

6. Système de commande pour appareil électrique comprenant:

(a) des premiers moyens de circuit comprenant des premiers moyens de commutation (22) pour connecter à la suite de leur activation et pour déconnecter à la suite de leur désactivation la charge de fonctionnement de l'appareil à une source d'alimentation électrique;

(b) des moyens de temporisation (24) pouvant fonctionner après leur alimentation électrique;

(c) des premiers moyens de piste de came (72);

(d) des seconds moyens de piste de came (70);

(e) des moyens de came de sous-intervalle (80) entraînés de façon opérative par les moyens de temporisation (24);

(f) des premiers moyens de circuit comprenant des seconds moyens de commutation (40) fontionnant à la suite de leur activation pour alimenter électriquement et à la suite de leur désactivation pour désalimenter électriquement les moyens de programmateur (24);

(g) des seconds moyens de circuit comprenant des troisièmes moyens de commutation (48) électriquement en parallèle avec les premiers moyens de commutation (22), les troisièmes moyens de commutation (48) agissant à la suite de leur activation pour connecter, et à la suite de leur désactivation pour déconnecter, la charge de fonctionnement de l'appareil à la ligne d'alimentation par l'intermédiaire desdits seconds moyens de commutation (40), les troisièmes moyens de commutation (48) comprenant des moyens de suiveur de came (94) agissant en réponse aux moyens de came de sous-intervalle (80) pour faire fonctionner de façon cyclique les troisièmes moyens de commutation (48);

(h) les seconds moyens de commutation (40) comprenant des moyens de suiveur de came (76) agissant en réponse à la seconde piste de came (70) pour faire fonctionner de façon cyclique lesdits moyens de temporisation, les premiers moyens de commutation (22) comprenant des moyens de suiveur de came (78) agissant en réponse à la première piste de came (72) pour faire fonctionner de façon cyclique la charge de fonctionnement de l'appareil;

(i) des moyens de commutation de sélection de mode (34) agissant à la suite d'un actionnement par l'utilisateur, caractérisé en ce qu'il s'agit d'un autre commutateur qui, quand il est activé à une première position, choisit les seconds moyens de circuit pour la circulation de courant vers les moyens de temporisation et agissant par suite d'une activation par l'utilisateur vers une autre position pour court-circuiter les seconds moyens de circuit et fournir du courant aux moyens de temporisation par l'intermédiaire des premiers moyens de circuit;

(j) les moyens de temporisation (24) agissant pour faire avancer un cliquet d'entraînement (58) capable d'intexer des moyens de roue à rochet (62), et les moyens de roue à rochet sont couplés de sorte que, quand ils sont indexes, les premiers et seconds moyens de piste de came sont indexés, les moyens de came de sous-intervalle (80) fonctionnant de façon cyclique avec une période de façon générale égale à l'avance cyclique du cliquet, et

(k) les moyens de roue à rochet (62) comprennent des moyens de retard (66) actionnables par suite du contact avec le cliquet (58) pour empêcher l'avance du cliquet de faire encore avancer le moyen de roue à rochet jusqu'à ce que le moyen de roue à rochet avance effectivement au-delà des moyens de retard, dans lequel la première piste de came amène les premiers moyens de commutation (22) à être désactivés quand les moyens de retard (66) empêche ledit indexage et les moyens de came de sous-intervalle (80) font fonctionner de façon cyclique l'alimentation vers la charge par l'intermédiaire des troisièmes moyens de commutation (48).

7. Système de commande selon la revendication 6, dans lequel les moyens de came de sous-intervalle (80) agissent pour activer les troisièmes moyens de commutation (48) pendant une petite partie de la durée de sous-intervalle.

8. Système de commande selon l'une des revendications 6 ou 7, dans lequel les moyens de retard (66) et la seconde piste de came (70) sont disposés pour maintenir les seconds moyens de commutation (40) activés pendant et au-delà de l'intervalle d'activation des premiers moyens de commutation (22) de sorte que les moyens de temporisation (24) continuent à faire fonctionner de façon cyclique lesdits moyens de came de sous-intervalle (80).

9. Système de commande selon l'une des revendications 6, 7 ou 8, comprenant en outre des moyens d'alarme fonctionnant en réponse à l'actionnement cyclique des moyens de came de sous-intervalle (80).

10. Système de commande selon l'une des revendications 6, 7, 8 ou 9, dans lequel les moyens de came de sous-intervalle (80) comprennent des moyens effectuant une liaison d'entraînement à perte de course avec les moyens de temporisation (24).

Fig. 1

0 128 634

Fig. 2

Fig.3

Fig.4

0 128 634